# EUROPEAN PATENT SPECIFICATION

(11) **EP 0 443 659 B1**
(45) Date of publication and mention of the grant of the patent: **26.07.1995**
(21) Application number: 91200263.1
(22) Date of filing: 08.02.1991
(51) Int. Cl.: C04B 41/45, C23C 16/44, C22C 33/02

(54) **A process for applying a coating on powdery particles and a process for the production of metallic objects by using these particles**
Verfahren zum Beschichten von Pulver und Verfahren zur Herstellung von Metallkörpern mit diesem Pulver
Procédé de revêtement de poudres et procédé de préparation d'articles métalliques à partir de cette poudre

(30) Priority: 14.02.1990 NL 9000346
(43) Date of publication of application: 28.08.1991
(73) Proprietor: XYCARB B.V., NL-5705 CS Helmond (NL)
(72) Inventor: Michorius, Marcel Maria, NL-5616 BX Eindhoven (NL); Haafkens, Maarten Hendrik, NL-5751 MS Deurne (NL)
(74) Representative: Van kan, Johan Joseph Hubert, Ir.

(56) References cited:
- EP-A- 0 209 132
- EP-A- 0 263 427
- US-A- 4 565 744
- PATENT ABSTRACTS OF JAPAN vol. 7, no. 259 (C-195)November 18, 1983& JP-A-58 141 375 (TAKASHI HIRATE ) August 22, 1983
- PATENT ABSTRACTS OF JAPAN vol. 11, no. 63 (C-406)February 26, 1987& JP-A-61 222 998 (AGENCY OF IND. SCIENCE & TECHNOL. ) October 3, 1986

## Description

The invention relates to a process for applying a ceramic coating of TiN or SiC on powdery particles of alumina and/or silicon carbide present in a reactor. Besides this the invention relates to a process for the production of metallic objects by using the powdery particles applied with such a coating

This process for applying a coating on powdery particles is in general known from JP-A-58-141 375 (Patent Abstracts of Japan, vol. 7 number 259 (C-195)), which discloses CVD coating (with or without plasma) in a fluidized bed. This Japanese patent application especially concerns the form of the reactor and concerns the use of the oscillation generator in order to keep the fluid bed moving. However the present invention concerns the specific circumstances to apply a specific coating on specific powdery starting materials and concerns the use of coated powder for the production of objects having a high density. Said Japanese patent application does not give any information concerning these last aspects.

From European patent application 252 480 a process is known for coating objects with a carbide- or nitride layer in a fluid bed, but in this process the object to be coated hangs in the fluid bed, while according to the present process the powder, forming the fluid bed, is coated.

From Dutch patent application 6602476 a process is known to strengthen tungsten particles by bringing magnesia into the particles of tungsten. Bringing the magnesia into the innerside of the particles of tungsten is possible in a fluid bed by coating the tungsten particles with a layer of tungsten chloride, during which coating process the MgO-particles are applied to the tungsten particles and then tungsten chloride is applied to tungsten. However according to the present process, the powdery particles of the fluid bed are coated at the outer side evenly with a different material in regard with the particles forming the fluid bed.

According to US patent 3,248,612 an electrode has been obtained, by firstly applying a layer of tantalum to ceramic particles. However according to the present process no metallic layer is applied on ceramic particles. Also according to Dutch patent application 236.004 and British patent 896,600 a metallic coating is applied on a substrate, so that a catalyst has been obtained for which the catalytic metal is applied on a substrate such as alumina. These both patent publications do not give a process for applying a ceramic coating on powdery particles forming the fluid bed.

US patent 4,792,353 discloses a process for providing a coating on powdery alumina having a particle size of less than 0.1 mm. The coating material is e.g. titanium carbide formed by leading a vaporous mixture of TiCl₄ + CH₄ + argon into the reactor. The reaction takes place in a plasma reactor, whereby a high frequency coil is provided around the reactor. The use of this reactor is not clearly indicated in said US Patent Specification, but it is described clearly in an article in Advanced Ceramic Materials 3 (4) 341 - 344 (1988), which mentions as one of the authors Bruce M. Kramer, who is also mentioned as first inventor in US patent 4,792,353. In figure 1 on page 342 of said article it is clearly indicated that the flow of argon is led through a fluid bed, in which powdery alumina is present, said powdery alumina being supplied, together with the TiCl₄-containing vapour flow, to a plasma reactor. It has now become possible to obtain a simpler process and still to apply a more evenly distributed coating around the powdery starting material.

This can be obtained according to the process according to the invention being a process for applying a ceramic coating of TiN or SiC on powdery particles of alumina and/or silicon carbide, present in a reactor, excluding a plasma reactor, in which a fluid bed is formed with these particles, by supplying to the hydrogen comprising gas stream for fluidizing the powder, TiCl₄ or SiCl₄ to which is added either a lower hydrocarbon for applying the SiC coating or nitrogen for applying the TiN coating, the temperature of the fluid bed being maintained between 800 and 2000 °C. Thus, the coating is applied according to a CVD-technique (chemical vapour deposition) and it is preferred that as a lower hydrocarbon one adds methane or ethane to the SiCl₄ comprising hydrogen stream.

According to the present process one also produces steel objects by sintering powdery steel. The sintered product is improved by adding alumina and the density of the steel end product can be improved by coating this alumina with a ceramic material such as TiN, or SiC. The metal objects are then produced by mixing the metallic powder, which can be sintered, with 2-15 wt.% alumina having the ceramic coating, after which the obtained mixture is pressed in a form and is sintered under the cover of a protecting gas or under vacuum at a temperature of 1100-1200 °C. Such an object has a density being more than 99% of the theoretically density. Coated silicon carbide may be used instead of coated alumina.

The powdery material used as starting material in the fluid bed has preferrably a diameter of 20-70 »m. The invention is further explained with reference to the following examples.

### Example I

A column having a diameter of 75 mm and a height of 500 mm was connected to a gas mixing system. The lower section of the column functions as a pressure distributing chamber. On the lower section there is a porous plate which is resistant to the high temperatures occurring during the process. Because of the pressure drop across the porous plate the gas distribution is homogeneous across the surface of the porous plate. The column above the porous plate was filled with ceramic powder to a height of 150 mm. The column was closed at its upper end by a porous plate or by a gauze, in order to prevent as much powder from being carried along as possible. The column was hermetically sealed from the air by means of a reactor vessel. The reactor vessel was electrically heated up to the required reaction temperature by means of a resistance oven. During warming-up gas was led into the pressure distributing chamber, above which the porous plate was located. The gas was homogeneously distributed over the column diameter, as a result the powder was fluidized. After the column had reached the reaction temperature, required for the predetermined deposition of the coating on the powder, the reaction vapour was supplied and reacted in the column so as to form the required coating on the powdery particles.

In order to form titanium nitride on alumina the following reaction was used:

2 TiCl₄ + 4 H₂ + N₂ → 2 TiN + 8 HCl

Titanium tetrachloride was charged to the gas mixing system in hydrogen and nitrogen, by heating titanium tetrachloride in a vessel and leading the gases across said titanium tetrachloride. The nitrogen/hydrogen ratio was 1, whereby sufficient hydrogen was supplied so that the above mentioned reaction could take place, whilst the titanium tetrachloride concentration was maintained at 10 vol.%. The pressure in the column was 1 bar and the reaction temperature was 900 °C. The total vapour flow through the column was 10 Nl/min. A relatively small amount of powder was carried along from the column (carry-over). The particle size distribution of the powder was 20 - 70 »m.

### Example II

In this Example a column of the kind indicated in Example I was used, as well as the general process described in said Example. In order to form titanium nitride on silicon carbide the following reaction was used:

2 TiCl₄ + 4 H₂ + N₂ → 2 TiN + 8 HCl

Titanium tetrachloride was charged to the gas mixing system of hydrogen and nitrogen, by heating titanium tetrachloride in a vessel and leading the gases across said titanium tetrachloride. The nitrogen/hydrogen ratio was 1, whilst the concentration of titanium tetrachloride was 10 vol.%. The pressure in the column was 1 bar and the reaction temperature was 900 °C. The total flow through the column was 10 Nl/min, with a carry-over of maximally 40 vol.% of the initial fluid bed volume. The particle size distribution of the powder was 80 - 150 »m.

### Example III

A column and process such as described in Example I were used. In order to form silicon carbide on alumina the following reaction was used:

2 SiCl₄ + C₂H₆ + H₂ → 2 SiC + 8 HCl

Silicon tetrachloride was charged to the gas mixing system of hydrogen and ethane, by heating silicon tetrachloride in a vessel and leading the gases across said silicon tetrachloride. The concentration of silicon tetrachloride was 5 vol.%, the ethane concentration was 5 vol.% and the pressure in the column was 1 bar. The reaction temperature was 1150 °C and the total flow through the column was 8 Nl/min.

The particle size distribution of the powder was 20 - 70 »m and the powder was evenly covered with a coating of silicon carbide.

### Example IV

The process according to exmple I is repeated however by using a column having a diameter of 150 mm and a height of 750 mm. The filling height of the ceramic powder is 250-400 mm. The total gas stream is regulated on 15-25 l/min. With this column, alumina is coated with titanium nitride. The obtained coated powder was comparable with the result of example I.

### Example V

For the production of a metal object, metallic powder comprising 91.75 wt.% powdery rapid steel, 8 wt.% Cu₃P, 0.25 wt.% C and 0.6 wt.% parrafin is mixed with 8 wt.% alumina (calculated on basis of the metallic powder), which alumina is coated according to example I. Mixing is carried out in a mixing device during about 15 minutes. Then the mixture is pressed in a isostatic press, so that the minimum density of the pressed object is 50% of the theoretical density. Then this semi-product is sintered at a temperature between 1120 and 1180 °C using a protecting gas of nitrogen/hydrogen. Instead of the gas mixture of nitrogen/hydrogen, one also can carry out the pressing under vacuum. After this sintering the obtained object, in the form of a plate, has a density higher than 99% of the theoretical density. Besides this this object has the desired hardness, being higher than 60 HRC.

The density of the steel object, obtained by mixing powdery steel with uncoated alumina was 95%, while for the product obtained by mixing the powdery steel with alumina having the coating, the density was 99.5%, calculated on basis of the theoretical density.

## Claims

1. A process for applying a ceramic coating of TiN or SiC on powdery particles of alumina and/or silicon carbide, present in a reactor, excluding a plasma reactor, in which a fluid bed is formed with these particles, by supplying to the hydrogen comprising gas stream for fluidizing the powder, TiCl₄ or SiCl₄ to which is added either a lower hydrocarbon for applying the SiC coating or nitrogen for applying the TiN coating, the temperature of the fluid bed being maintained between 800 and 2000 °C.

2. A process according to claim 1, in which the powdery particles in the fluid bed have a size of 20-70 »m.

3. A process for the production of metal objects by mixing powdery steel with 2-15 wt.% of a coated alumina and/or coated silicon carbide and pressing and sintering the mixture, wherein the coating has been carried out according to a process as disclosed in claims 1-2.

## Patentansprüche

1. Verfahren zum Auftragen einer keramischen Beschichtung aus TiN oder SiC auf pulverförmige Partikel von Aluminiumoxid und/oder Siliziumcarbid, die in einem Reaktor, unter Ausnahme eines Plasmareaktors, vorhanden sind, worin eine Fließbett aus diesen Partikeln gebildet wird, indem zu dem Wasserstoff enthaltenden Gasstrom zur Fluidisierung des Pulvers TiCl₄ oder SiCl₄ zugefügt wird, wobei entweder ein niedriger Kohlenwasserstoff zum Auftragen der SiC-Schicht oder Stickstoff zum Auftragen der TiN-Schicht zugesetzt ist und die Temperatur des Fließbettes zwischen 800 und 2000 °C gehalten wird.

2. Verfahren nach Anspruch 1, worin die pulverförmigen Partikel in dem Fließbett eine Größe von 20 -70 »m haben.

3. Verfahren zur Herstellung von Metallkörpern durch Mischen von pulverförmigem Stahl mit 2 - 15 Gew.% beschichtetem Aluminiumoxid und/oder beschichtetem Siliziumcarbid und Fressen und Sintern dieses Gemisches, wobei die Beschichtung nach einem Verfahren gemäß den Ansprüchen 1-2 durchgeführt wurde.

## Revendications

1. Procédé pour appliquer un enrobage céramique de TiN ou de SiC sur des particules pulvérulentes d'alumine et/ou de carbure de silicium, présentes dans un réacteur, à l'exclusion d'un réacteur à plasma, dans lequel on forme un lit fluide de ces particules, en chargeant, dans le courant de gaz comprenant de l'hydrogène, pour fluidiser la poudre, TiCl₄ ou SiCl₄, auquel on ajoute soit un hydrocarbure inférieur pour appliquer l'enrobage de SiC, soit de l'azote pour appliquer l'enrobage de TiN, la température du lit fluide étant maintenue entre 800 et 2 000°C.

2. Procédé selon la revendication 1, dans lequel les particules pulvérulentes dans le lit fluide ont une granulométrie de 20-70 »m.

3. Procédé de production d'objets métalliques qui consiste à mélanger de l'acier pulvérulent avec 2-15% en poids d'une alumine enrobée et/ou d'un carbure de silicium enrobé et à presser et à fritter le mélange, dans lequel l'enrobage a été réalisé selon le procédé décrit dans les revendications 1-2.
